# EUROPEAN PATENT APPLICATION

(11) **EP 2 230 334 A1**
(43) Date of publication of application: **22.09.2010**
(21) Application number: 08859773.7
(22) Date of filing: 11.12.2008
(51) Int. Cl.: C30B 29/38, H01L 21/203, H01L 21/205, H01L 33/00

(54) **MULTILAYER SUBSTRATE INCLUDING GaN LAYER, METHOD FOR MANUFACTURING THE MULTILAYER SUBSTRATE INCLUDING GAN LAYER, AND DEVICE**

(30) Priority: 13.12.2007 JP 2007321605
(71) Applicant: Shin-Etsu Chemical Co., Ltd., Tokyo 100-0004 (JP)
(72) Inventor: AKIYAMA, Shoji, Annaka-shi Gunma 379-0195 (JP)
(74) Representative: Vossius & Partner
(86) International application number: PCT/JP2008/072494
(87) International publication number: WO 2009/075321

(57) **Abstract**

A GaN layer-containing multilayer substrate employing as a substrate a single crystal that can be made to have a large diameter, a process for producing same, and a device employing the multilayer substrate. The process for producing a multilayer substrate of the present invention includes a germanium growing step of heteroepitaxially growing a germanium layer above a (111) silicon substrate by chemical vapor deposition, a heat treatment step of carrying out a heat treatment of the obtained germanium layer above the silicon substrate in a temperature range of 700°C to 900°C, and subsequently a GaN growing step of heteroepitaxially growing a GaN layer above the germanium layer.

## Description

The present invention relates to a GaN layer-containing multilayer substrate, a process for producing same, and a device employing the multilayer substrate.

In recent years, the use of GaN crystals in device applications such as light-emitting diodes (LED) and heterojunction bipolar transistors (HBT) has been attracting attention. It is usually very difficult to grow GaN bulk crystals, the price is very high, the size of a substrate is 2 to 3 inches, and there is the problem that it is difficult to reduce the cost. In order to avoid this problem, GaN for use in LEDs is grown heteroepitaxially on single crystal SiC or single crystal sapphire.

However, single crystal SiC and single crystal sapphire are also expensive, and there is no substrate having a large diameter, thus preventing them from becoming widely used. Furthermore, there is a large lattice mismatch between these materials and GaN, and when growing GaN it is necessary to provide a buffer layer, thereby greatly degrading productivity.

In recent years, in order to avoid these problems, the use of germanium (111) bulk crystals has been proposed (Non-Patent Document 1). Although germanium (111) and GaN have a high lattice mismatch (about 20%), since the mesh ratio of the two is 5:4, the actual lattice mismatch is on the order of 0.4%. That is, the positions of the lattices coincide with each other when the unit cell of (111) germanium is repeated 5 times and the unit cell of GaN is repeated 4 times. However, this method also has a problem. It can be said that, with regard to germanium, a substrate having a large diameter is more easily obtained than with single crystal SiC, etc., but since germanium is a rare element, the price is very high and it is difficult to obtain.
(Non-Patent Document 1) "Germanium - a surprise base for high-quality nitrides" Compound Semiconductor, pp. 14-16, April 2007

It is an object of the present invention to provide a GaN layer-containing multilayer substrate employing as a substrate a single crystal that can be made to have a large diameter, a process for producing same, and a device employing the multilayer substrate.

The above object has been accomplished by means (1), (3), and (4) below. They are listed together with (2) and (5), which are preferred embodiments.
(1) A process for producing a GaN layer-containing multilayer substrate, the process comprising a germanium growing step of heteroepitaxially growing a germanium layer above a (111) silicon substrate by chemical vapor deposition, a heat treatment step of carrying out a heat treatment of the obtained germanium layer above the silicon substrate in a temperature range of 700°C to 900°C, and subsequently a GaN growing step of heteroepitaxially growing a GaN layer above the germanium layer,
(2) the process for producing a GaN layer-containing multilayer substrate according to (1), wherein a SiGe layer is heteroepitaxially grown above the silicon substrate prior to the germanium growing step,
(3) a GaN layer-containing multilayer substrate comprising at least a single crystal silicon substrate, a germanium layer grown heteroepitaxially above the silicon substrate, and a GaN layer grown heteroepitaxially above the germanium layer, the germanium layer having no threading dislocation, and dislocations being localized in the vicinity of the interface between the silicon substrate and the germanium layer,
(4) a device fabricated using the GaN layer-containing multilayer substrate according to (3), and
(5) the device according to (4), wherein the device is an LED device or an HBT device.

In accordance with the production process of the present invention, since a (111) silicon wafer is used as the substrate, a GaN layer-containing multilayer substrate employing a substrate having a large diameter of 8 inches or greater can be produced at low cost. Furthermore, threading dislocations occurring in the germanium layer, which is heteroepitaxially grown, can be eliminated by the heat treatment step. The GaN layer-containing multilayer substrate of the present invention may be used in the production of a device such as a light-emitting diode (LED) device or a heterojunction bipolar transistor (HBT) device.
(FIG. 1) A schematic cross-sectional view showing one example of the GaN-containing multilayer substrate of the present invention.
(FIG. 2) A flow diagram showing one example of the process for producing a GaN-containing multilayer substrate of the present invention.
(FIG. 3) A schematic cross-sectional view showing changes in dislocation resulting from a heat treatment step of the production process of the present invention.
   - 1: GaN layer-containing multilayer substrate
   - 3: (111) Silicon substrate
   - 5: SiGe layer
   - 7: Germanium layer
   - 9: GaN layer
   - 11: Threading dislocation
   - 13: Dislocation

### <GaN layer-containing multilayer substrate and process for producing same>

The process for producing a GaN layer-containing multilayer substrate of the present invention comprises a germanium growing step of heteroepitaxially growing a germanium layer above a (111) silicon substrate by chemical vapor deposition (CVD), a heat treatment step of carrying out a heat treatment of the obtained germanium layer above the silicon substrate in a temperature range of 700°C to 900°C, and a GaN growing step of heteroepitaxially growing GaN above the germanium layer.

The above-mentioned three essential steps are explained below by reference to the drawings.

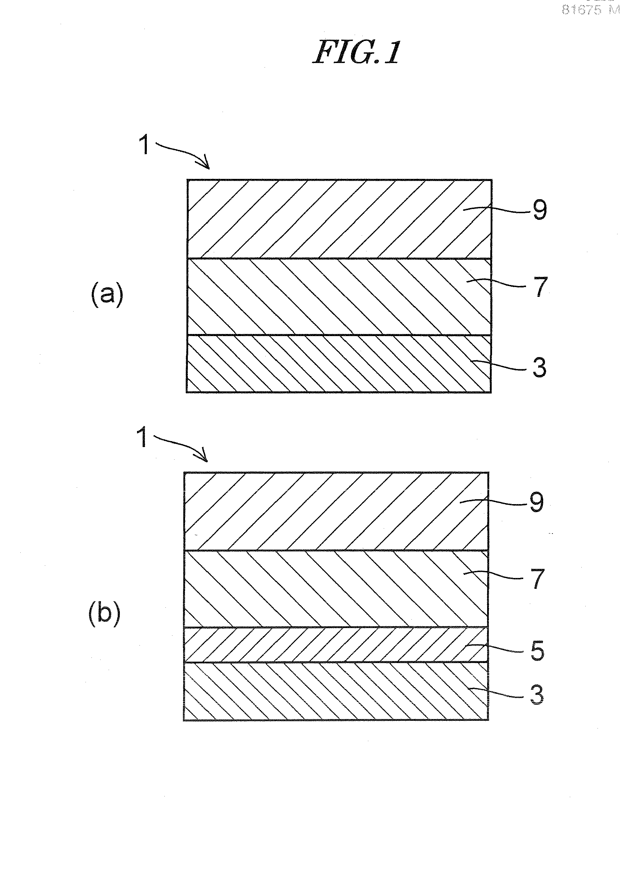

As schematically shown in the cross-sectional view of FIG. 1 (a), the GaN layer-containing multilayer substrate 1 of the present invention has, above a (111) silicon substrate 3, a germanium layer 7 and a GaN layer 9 as essential layers. As schematically shown in the cross-sectional view of FIG. 1 (b), it may have a SiGe layer 5 as a buffer layer between the silicon substrate 3 and the germanium layer 7.

The process for producing a GaN layer-containing multilayer substrate comprises the above-mentioned three steps, that is, the germanium growing step, the heat treatment step, and the GaN growing step, and it is preferable for the three steps to be carried out in this order. However, this should not be construed as excluding another step being included in the course of the three steps.

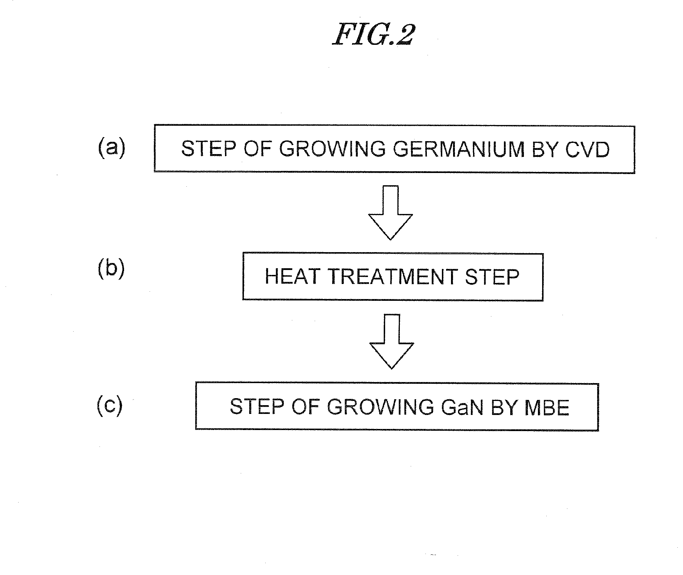

FIG. 2 is a process diagram showing one embodiment of the above-mentioned production process.

### (Germanium growing step)

In the production process of the present invention, a silicon substrate is used as a substrate; in particular, it is preferable to use a (111) silicon substrate, and it is more preferable to use a single crystal (111) silicon wafer. Selection of the diameter of the substrate may be up to a large diameter of 8 to 10 inches.

The lattice constant of silicon (111) is 3.84 Å, and the lattice constant of germanium (111) is 4.00 Å. The lattice mismatch between silicon and germanium is 4%.

In order to heteroepitaxially grow germanium above a (111) silicon substrate, chemical vapor deposition (CVD) is employed.

Germanium growth conditions may be in accordance with conditions described in L. Colace et al., Appl. Phys. Lett. 72 (1998) 3175. By carrying out growth using GeH₄ as the gas under ultra high vacuum (no greater than 2 × 10⁻⁸ Pa) at 600°C, a film having a thickness of about 200 nm can be grown. It is preferable for the germanium layer to have a thickness of 50 to 500 nm.

### (Heat treatment step)

As hereinbefore described, since the lattice mismatch between silicon and germanium is 4%, a large number of threading dislocations (dislocations occurring in the threading direction of the germanium layer) are produced in the germanium layer. However, by subjecting it to an additional heat treatment it is possible to concentrate the dislocations in the vicinity of the interface between the silicon substrate and the germanium layer.

In this process, the heat treatment may be carried out using an ordinary diffusion furnace under conditions of an N₂ atmosphere/normal pressure at a temperature of 700°C to 900°C for a time of 0.5 to 3 hours, and preferably at a temperature of about 800°C for a time of about 1 hour.

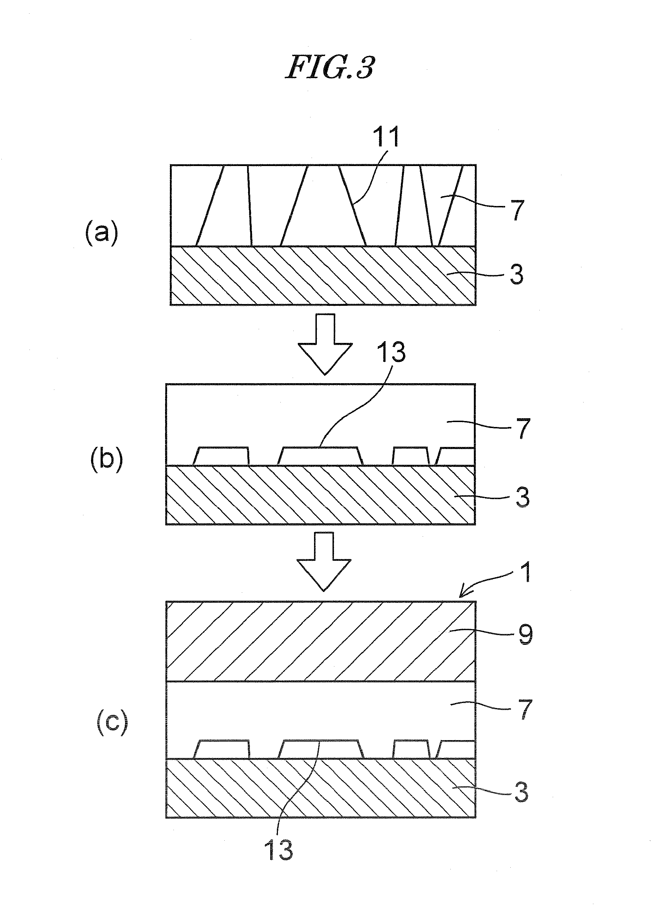

FIG. 3 schematically shows changes caused by the heat treatment. As shown in FIG. 3 (a), threading dislocations 11 present in the germanium layer 7 are modified by the above-mentioned heat treatment into dislocations 13 in the vicinity of the interface between the silicon substrate 3 and the germanium layer 7 as shown in FIG. 3 (b). Furthermore, by heteroepitaxially growing (described later) the GaN layer 9, the GaN layer 9 can be grown on the germanium layer 7 as shown in FIG. 3 (c).

A germanium film on a (001) silicon substrate has been reported in the following reference. (M. Halbwax et al., "UHV-CVD growth and annealing of thin fully relaxed Ge films on (001) Si", Optical Materials, 27 (2005), pp. 822-825).

It can be expected that, when threading dislocations appear on the surface of a germanium (Ge) layer, these defects will also be transmitted to the growing GaN film. Since the emission intensity decreases greatly around the threading dislocations thus transmitted, this becomes a serious problem when producing a light-emitting device. However, by subjecting the heteroepitaxially grown Ge layer to a heat treatment it is possible to modify threading dislocations in the Ge layer into dislocations that are localized in the vicinity of the interface between the silicon substrate and the Ge layer. Therefore, by modifying the dislocations into a loop shape by the heat treatment step, not only is a high quality GaN film finally obtained, but there is also the advantage that it is easy to make a contact since, unlike SiC or sapphire, silicon is conductive.

### (SiGe layer formation step)

It is of course possible to form between the silicon substrate and the germanium layer a buffer layer for relaxing the lattice mismatch. As the buffer layer a SiGe layer is preferable. The buffer layer may be formed by heteroepitaxial growth employing chemical vapor deposition (CVD).

A SiGe film may be grown using GeH4 and SiH₄ as gases under ultra high vacuum (no greater than 2 × 10⁻⁸ Pa) at 600°C. The thickness of the SiGe layer is preferably about 10 to 100 nm, and more preferably 20 to 50 nm.

### (GaN layer growing step)

A GaN layer is heteroepitaxially grown above the above-mentioned germanium lawyer. A GaN heteroepitaxial film having the same size as that of the silicon substrate can be obtained by this GaN growing step. As methods for growing a GaN layer, there are molecular beam epitaxy (Molecular Beam Epitaxy: MBE) and metal organic vapor phase epitaxy (Metal Organic Chemical Vapor Deposition: MOCVD), and MBE is preferable. MBE enables a film to be formed at 800°C or less, whereas since MOCVD generally requires 1,000°C to 1,100°C it is difficult to create conditions for germanium, which has a melting point of 940°C.

### (MBE)

MBE is one of the techniques used in semiconductor crystal growth. It is classified as a vacuum vapor deposition method; GaN released as a molecular beam from a starting material supply mechanism grows as a thin film on a deposition target.

Growth is carried out under ultra high vacuum (on the order of 10⁻⁸ Pa). By selecting the conditions, GaN can be grown epitaxially by deposition while maintaining the orientational relationship. Equipment used here is known to a person skilled in the art and may be referred to in, for example, Shunichi Gonda 'Molecular Beam Epitaxy' (Baifukan).

### <GaN layer-containing multilayer substrate>

The GaN layer-containing multilayer substrate of the present invention comprises at least a single crystal silicon substrate, a germanium layer grown heteroepitaxially above the silicon substrate, and a GaN layer grown heteroepitaxially above the germanium layer, the germanium layer having no threading dislocations, and dislocations being localized in the vicinity of the interface between the silicon substrate and the germanium layer.

The GaN layer-containing multilayer substrate is explained below, but only a brief explanation is given since it is substantially the same as the explanation given above for the process for producing a GaN layer-containing multilayer substrate.

### (Examination of dislocations)

Examination of dislocations within the germanium layer may be carried out using a transmission electron microscope (TEM).

### <Production of device employing GaN layer-containing multilayer substrate>

The GaN layer-containing multilayer substrate of the present invention may be widely used for the production of a device.

This device includes an LED device and an electronic device, and examples of the electronic device include an HBT device.

As the LED device (light-emitting device), a blue light-emitting device may be produced, and it may be produced by a known method.

Compared with a case in which a gallium nitride blue light-emitting device is produced by a homoepitaxial growth method, a device fabricated using the GaN layer-containing multilayer substrate of the present invention is advantageous in terms of low cost. Bulk GaN, which is used in the homoepitaxial growth method, has a small diameter and is very expensive, but in the method of the present invention a silicon substrate having a large diameter can be used as a starting substrate, and it is therefore possible to produce a GaN device at a very low cost that is different by several orders of magnitude.

An HBT device (heterojunction bipolar transistor device) employing a gallium nitride semiconductor may be produced by a known method. Specific production processes are diverse, and may be selected as appropriate by a person skilled in the art.

### (Example 1)

(111) Germanium was epitaxially grown directly on a (111) silicon substrate by chemical vapor deposition (CVD) on the silicon at a thickness of about 100 nm, and a heat treatment at 800°C was carried out. Subsequently, GaN was grown by MBE to give an approximately 50 nm GaN film. When this GaN film was analyzed by X ray diffraction, a sharp peak of on the order of 380 arcsec was observed, thus confirming the growth or a GaN single crystal.

When a cross-section of the GaN layer-containing multilayer substrate thus obtained was examined by TEM (Transmission Electron Microscopy), no threading dislocations were observed in the germanium layer, and dislocations were localized in the vicinity of the interface between the silicon substrate and the germanium layer.

### (Example 2)

A (111) SiGe layer was grown at on the order of 30 nm on a (111) silicon substrate by chemical vapor deposition (CVD) using SiH₄ gas and GeH₄ gas, subsequently a (111) germanium layer was epitaxially grown, and a heat treatment at 800°C was carried out. Subsequently, GaN was grown by MBE to give an approximately 50 nm GaN film. When this GaN film was analyzed by X ray diffraction, a sharp peak of on the order of 380 arcsec was observed as in Example 1, thus confirming the growth of a GaN single crystal.

When a cross-section of the GaN layer-containing multilayer substrate thus obtained was examined by TEM, no threading dislocations were observed in the germanium layer, and dislocations were localized in the vicinity of the interface between the SiGe layer and the germanium layer.

### (Example 3)

An experiment was carried out in the same manner as in Example 2 using an 8 inch (111) silicon substrate.

The GaN film thus formed was analyzed by X ray analysis for a central portion and a portion 1 cm away from the peripheral edge. There was no significant difference between the two portions, and sharp peaks were observed for the two.

## Claims

1. A process for producing a GaN layer-containing multilayer substrate, the process comprising:
a germanium growing step of heteroepitaxially growing a germanium layer above a (111) silicon substrate by chemical vapor deposition;
a heat treatment step of carrying out a heat treatment of the obtained germanium layer above the silicon substrate in a temperature range of 700°C to 900°C; and subsequently
a GaN growing step of heteroepitaxially growing a GaN layer above the germanium layer.

2. The process for producing a GaN layer-containing multilayer substrate according to Claim 1, wherein a SiGe layer is heteroepitaxially grown above the silicon substrate prior to the germanium growing step.

3. A GaN layer-containing multilayer substrate comprising at least:
a single crystal silicon substrate, a germanium layer grown heteroepitaxially above the silicon substrate, and a GaN layer grown heteroepitaxially above the germanium layer,
the germanium layer having no threading dislocation, and
dislocations being localized in the vicinity of the interface between the silicon substrate and the germanium layer or the vicinity of the interface between a SiGe layer and the germanium layer.

4. A device fabricated using the GaN layer-containing multilayer substrate according to Claim 3.

5. The device according to Claim 4, wherein the device is an LED device or an HBT device.
